# EUROPEAN PATENT APPLICATION

(11) **EP 4 561 313 A1**
(43) Date of publication of application: **28.05.2025**
(21) Application number: 23856434.8
(22) Date of filing: 03.08.2023
(51) Int. Cl.: H10K 59/10

(54) **DISPLAY PANEL AND DISPLAY APPARATUS**

(30) Priority: 23.08.2022 CN 202211012747
(71) Applicant: Huawei Technologies Co., Ltd., Shenzhen, Guangdong 518129 (CN)
(72) Inventor: DONG, Yujie, Shenzhen, Guangdong 518129 (CN); LIU, Guohe, Shenzhen, Guangdong 518129 (CN)
(74) Representative: Pfenning, Meinig & Partner mbB
(86) International application number: PCT/CN2023/110986
(87) International publication number: WO 2024/041344

(57) **Abstract**

A display panel (100) is provided, including a first electrode layer (10), an organic light-emitting layer (20), and a second electrode layer (30) that are sequentially stacked. The display panel (100) is divided into a display area (120) and a frame area (110). The frame area (110) includes a first end side area (111) and a second end side area (111) that are opposite to each other. The display panel (100) includes a first flexible circuit board (50) disposed in the first end side area (111), a second flexible circuit board (60) disposed in the second end side area (111), and two power cables (70). The first flexible circuit board (50) and the second flexible circuit board (60) obtain, through respective cables (51 and 61), a drive signal provided for the first electrode layer (10). One end of each power cable (70) is connected to the cable (51) of the first flexible circuit board (50), and the other end is connected to the cable (61) of the second flexible circuit board (60). A resistivity of the power cable (70) is higher than a resistivity of the cable (51) of the first flexible circuit board (50) and a resistivity of the cable (61) of the second flexible circuit board (60). This application further provides a display apparatus (200) including the display panel (100). The cable (61) disposed on the second flexible circuit board (60) is connected to the power cable (70), to implement a low-impedance design of the power cable (70) and reduce a voltage drop.

## Description

### CROSS-REFERENCE TO RELATED APPLICATIONS

This application claims priority to Chinese Patent Application No. 202211012747.X, filed with the China National Intellectual Property Administration on August 23, 2022 and entitled "DISPLAY PANEL AND DISPLAY APPARATUS", which is incorporated herein by reference in its entirety.

### TECHNICAL FIELD

This application relates to a display panel and a display apparatus including the display panel.

### BACKGROUND

An organic light-emitting diode (Organic Light-Emitting Diode, OLED) display is a display made of an organic light-emitting diode. When different drive voltages are applied to a cathode and an anode at two ends of the light-emitting diode, the light-emitting diode emits light. In an existing OLED display product, a power cable is usually disposed inside a display panel to provide a drive voltage for light emitting of a light-emitting diode. However, the power cable is usually a TiAlTi (titanium-aluminum-titanium) cable with a large resistivity, which leads to limited improvement of a voltage drop (IR Drop). Increasing a width of the power cable may reduce the voltage drop to a specific extent, but affects space of the display panel and a narrow frame design of an entire device. The voltage drop is a voltage consumed by supplying power from a chip source to an element (for example, an electrode layer). A voltage actually obtained by the element (for example, the electrode layer) is a power supply voltage minus the voltage drop.

### SUMMARY

According to a first aspect, an embodiment of this application provides a display panel, including a first electrode layer, an organic light-emitting layer, and a second electrode layer that are sequentially stacked, where the display panel is divided into a display area and a frame area, the frame area includes a first end side area and a second end side area that are opposite to each other, and two opposite side areas that are connected between the first end side area and the second end side area, and the display panel includes:
a first flexible circuit board disposed in the first end side area and a second flexible circuit board disposed in the second end side area, where the first flexible circuit board and the second flexible circuit board obtain, through respective cables, a drive signal provided by a mainboard for the first electrode layer; and
two power cables, where each power cable has two opposite ends, one end of each power cable is connected to the cable of the first flexible circuit board, and the other end is connected to the cable of the second flexible circuit board, for the two power cables, the cable of the first flexible circuit board, and the cable of the second flexible circuit board to be connected to form a loop, and the two power cables are both electrically connected to the first electrode layer.

In implementations of this application, a resistivity of the power cable is higher than a resistivity of the cable of the first flexible circuit board and a resistivity of the cable of the second flexible circuit board.

According to the display panel in this application, the first flexible circuit board and the flexible circuit board are cleverly used to connect to a drive signal, the cable (for example, a metal copper material) with a low resistivity is disposed to connect to and lead out the drive signal, and the cable is connected to the power cable (for example, a TiAlTi three-layer stacked structure) with a high resistivity, so that a low-impedance layout design of the power cable can be implemented, a voltage drop can be reduced, and a display effect can be improved.

In implementations of this application, the first flexible circuit board is a display flexible circuit board, and the second flexible circuit board is a touch flexible circuit board.

The first flexible circuit board is the display flexible circuit board, and is configured to transmit an input signal related to image displaying to each pixel, for example, a data signal, a power signal (like an ELVSS power signal), and a control signal. The second flexible circuit board is the touch flexible circuit board. The touch flexible circuit board is electrically connected to a touch layer, and is configured to transmit a touch drive signal to a touch electrode (for example, T_{X}) of the touch layer, and receive a sensing signal of a touch electrode (for example, R_{X}) of the touch control layer.

In implementations of this application, the two power cables are respectively disposed in the two different side areas.

The two power cables are respectively disposed in the different side areas, to ensure that both of the opposite sides of the first electrode layer can receive consistent drive signals.

**In** implementations of this application, the drive signal is an ELVSS voltage signal.

**In** implementations of this application, the first electrode layer is an entire layer covering at least the display area.

The first electrode layer is a cathode, is a continuous entire layer covering at least the display area, and is transparent to avoid affecting light emission of the organic light-emitting layer.

In implementations of this application, a material of the cable in the first flexible circuit board and a material of the cable in the second flexible circuit board are both metal copper.

A resistivity of the metal copper is low, so that a low-impedance layout design of the power cable can be well implemented.

In implementation of this application, the power cable is a TiAlTi cable.

The cable uses a TiAlTi three-layer stacked structure.

In implementations of this application, the display panel is flexible, and includes a main part, and a first bent part and a second bent part that are connected to two opposite ends of the main part, where the first bent part and the second bent part are bent relative to the main part and are stacked on a back surface of the main part.

The display panel is disposed to be flexible and bendable, so that a size of a front surface of the display apparatus occupied by the two end side areas can be effectively reduced.

In implementations of this application, the first flexible circuit board is disposed on the first bent part and is located on a surface that is of the first bent part and that is away from the main part, and the second flexible circuit board is disposed on the second bent part and is located on a surface that is of the second bent part and that is away from the main part.

In implementations of this application, the display panel includes a thin film transistor substrate stacked on a side that is of the second electrode layer and that is away from the organic light-emitting layer, and the thin film transistor substrate is flexible and includes a flexible base.

In implementations of this application, the display panel further includes a plurality of other power cables extending in the display area, the plurality of other power cables are connected in parallel and electrically connected to the first electrode layer, and the plurality of other power cables are electrically connected to the cable of the first flexible circuit board or the cable of the second flexible circuit board.

When the display panel is used in a tablet computer or another electronic apparatus with a display of a large size, a size of the first electrode layer is also large. To ensure that different areas of the first electrode layer can receive consistent drive voltage signals, so that display pixels are consistent, the plurality of other power cables are also disposed in the display area. However, the power cable needs to be disposed in an area between pixels, instead of an area in which a pixel is located.

According to a second aspect, an embodiment of this application provides a display apparatus that includes the display panel according to the first aspect of embodiments of this application and a polarizer and a transparent cover that are disposed on the display substrate.

In implementations of this application, the display apparatus further includes a touch layer stacked on the display panel.

In implementations of this application, the display apparatus further includes a display drive circuit board, the display drive circuit board is electrically connected to a mainboard to obtain a drive signal, and both a first flexible circuit board and a second flexible circuit board are electrically connected to the display drive circuit board to obtain the drive signal.

### BRIEF DESCRIPTION OF DRAWINGS

FIG. 1 is a cross-sectional diagram of an OLED display panel;
FIG. 2 is a top view of an OLED display panel according to an embodiment of this application;
FIG. 3 is a top view of an ELVSS power cable and a first electrode layer that are of an OLED display panel according to an embodiment of this application;
FIG. 4 is a side view of an OLED display apparatus according to an embodiment of this application;
FIG. 5 is a rear view of an OLED display apparatus according to an embodiment of this application; and
FIG. 6 is a cross-sectional diagram of a thin film transistor substrate of an OLED display panel according to an embodiment of this application.

### Description of reference signs of main elements

| | |
|---|---|
| OLED display | 100 |
| First electrode layer | 10 |
| Organic light-emitting layer | 20 |
| Second electrode layer | 30 |
| TFT substrate | 40 |
| Display area | 120 |
| Frame area | 110 |
| End side area | 111 |
| Side area | 113 |
| First flexible circuit board | 50 |
| Second flexible circuit board | 60 |
| ELVSS power cable | 70 |
| Drive chip | 80 |
| Display drive circuit board | 90 |
| Connector | 91 |
| Cable | 51 and 61 |
| Gate driver | 115 |
| Emission driver | 116 |
| Dummy circuit | 117 |
| Multiplexer | 118 |
| OLED display apparatus | 200 |
| Main part | 101 |
| First bent part | 102 |
| Second bent part | 103 |
| Polarizer | 210 |
| Transparent cover | 230 |
| Transparent optical adhesive | 250 |
| Package layer | 220 |

### DESCRIPTION OF EMBODIMENTS

The following describes embodiments of this application with reference to the accompanying drawings in embodiments of this application. Unless otherwise specified, a data range value recorded in this application should include an end value.

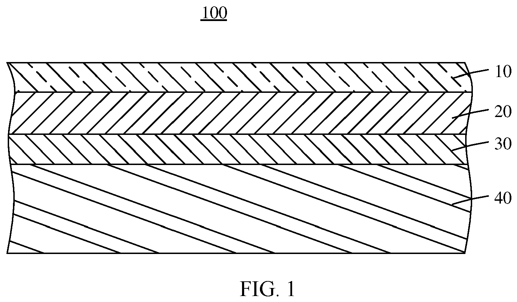

Refer to FIG. 1. An OLED display panel 100 includes a transparent first electrode layer 10, an organic light-emitting layer 20, a second electrode layer 30, and a substrate 40 that are sequentially stacked. In this embodiment, the substrate 40 is a thin film transistor (Thin Film Transistor, TFT) substrate. The organic light-emitting layer 20 is disposed between the first electrode layer 10 and the second electrode layer 30. The first electrode layer 10 and the second electrode layer 30 are a cathode and an anode of the organic light-emitting layer 20. When the first electrode layer 10 and the second electrode layer 30 receive different voltages so that there is a sufficient voltage difference between the first electrode layer 10 and the second electrode layer 30, the organic light-emitting layer 20 emits light. In this embodiment, the first electrode layer 10 is the cathode, and the second electrode layer 30 is the anode.

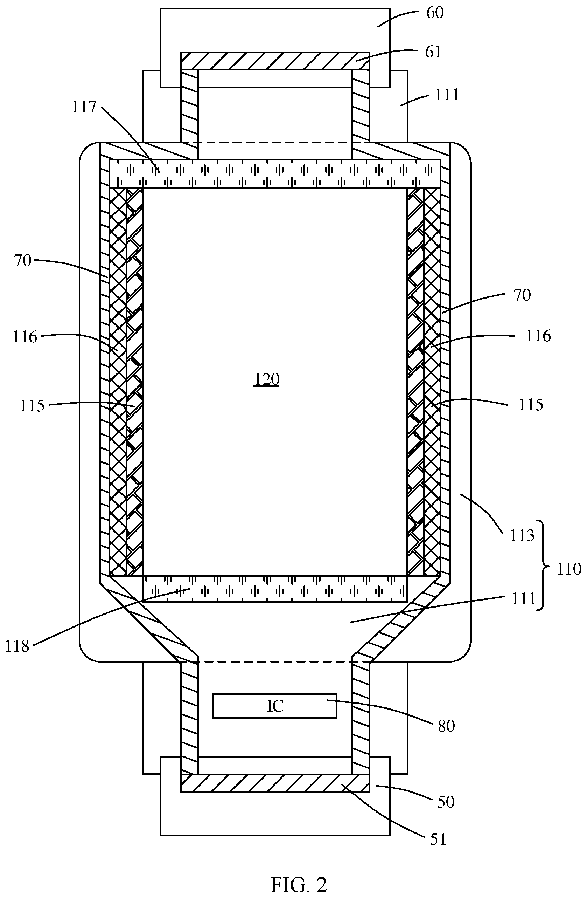

FIG. 2 is a planar top view of the OLED display panel 100. As shown in FIG. 2, an area of the OLED display panel 100 is divided, based on different functions, into a display area (Active Area, AA) 120 and a frame area 110 that is connected to and surrounds the display area 120. In this embodiment, the first electrode layer 10 is a continuous entire layer covering at least the display area 120, and is transparent to avoid affecting light emission of the organic light-emitting layer 20. A material of the first electrode layer 10 may be a transparent conductive material, which is usually indium tin oxide, but is not limited thereto. The display area 120 defines a plurality of pixels (not shown in the figure) arranged in a matrix, the second electrode layer 30 includes a plurality of electrodes that are spaced and insulated from each other, and each pixel corresponds to one electrode. The second electrode layer 30 is usually made of a metal material with good conductivity.

A power supply used by the OLED display usually includes an ELVDD power supply that provides a high-level voltage and an ELVSS power supply that provides a low-level voltage. ELVDD and ELVSS are drive voltages for the organic light-emitting layer 20 to emit light. In this embodiment, a voltage of the first electrode layer 10 may be provided by the ELVSS power supply, and an ELVSS power supply signal is transmitted to the first electrode layer 10 through an ELVSS power cable. A voltage of the second electrode layer 30 is provided by a circuit of the ELVDD power supply, and is controlled and transmitted to the electrodes corresponding to sub-pixels through the TFT substrate 40.

The OLED display is a current driving component. Current consistency of the pixels affects display brightness consistency. In the conventional technology, to ensure brightness uniformity, ELVSS power cables are usually disposed on two sides of a frame area of a display panel, to reduce a voltage drop (IR Drop) and improve a display effect. However, due to limited space in the display panel, it is difficult to further reduce impedance of the ELVSS power cable, which affects a display effect. For a tablet computer and a mobile phone with a large display, a larger screen indicates a higher difficulty in managing and controlling a voltage drop and a higher risk of a display effect.

Therefore, this application provides an OLED display panel, to reduce impedance of a power cable and reduce a voltage drop by designing a layout of the power cable. In embodiments of this application, a layout design of an ELVSS power cable is used as an example for description, but this is not limited thereto. For example, an ELVDD power cable can be laid out in a same way as the ELVSS power cable.

As shown in FIG. 2, the frame area 110 of the OLED display panel 100 includes two opposite end side areas 111 and two opposite side areas 113 connected between the two end side areas 111. For a portrait scenario of the display panel, the two end side areas 111 are located at an upper end and a lower end of the display area 120. For a landscape scenario of the display panel, the two end side areas 111 are located at a left end and a right end of the display area 120.

Refer to FIG. 2. The OLED display panel 100 includes a first flexible circuit board 50 and a second flexible circuit board 60. The first flexible circuit board 50 is located in one of the end side areas 111, and the second flexible circuit board 60 is located in the other end side area 111. The first flexible circuit board 50 and the second flexible circuit board 60 are located at two opposite ends of the display area 120. The end side areas 111 are separately named as a first end side area and a second end side area, the first flexible circuit board 50 is located in the first end side area, and the second flexible circuit board 60 is located in the second end side area.

In this embodiment, the first flexible circuit board 50 is a display flexible circuit board, and is configured to transmit an input signal related to image displaying to each pixel, for example, a data signal, a power signal (like an ELVSS power signal), and a control signal. A cable 51 is disposed in the first flexible circuit board 50 to connect to and transmit an ELVSS power supply signal.

In this embodiment, the second flexible circuit board 60 is a touch flexible circuit board. The touch flexible circuit board is electrically connected to a touch layer (not shown in the figure), and is configured to transmit a touch drive signal to a touch electrode (for example, T_{X}) of the touch layer, and receive a sensing signal of a touch electrode (for example, R_{X}) of the touch control layer. A cable 61 is also disposed in the second flexible circuit board 60 to connect to and transmit an ELVSS power supply signal.

In another embodiment, the second flexible circuit board 60 may also be a flexible circuit board that is additionally disposed for layout of the power cable, instead of a touch flexible circuit board.

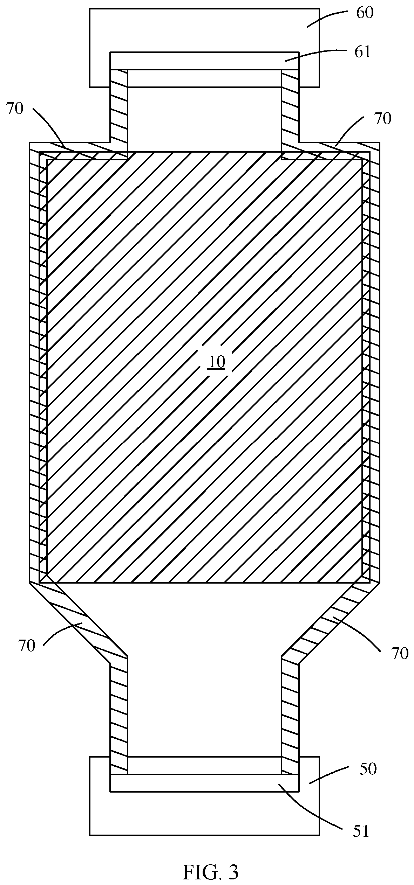

Refer to FIG. 3. The display panel includes an ELVSS power cable 70. The ELVSS power cable 70 is electrically connected to the first electrode layer 10, and an ELVSS power signal is transmitted to the first electrode layer 10 through the ELVSS power cable 70. The ELVSS power cable 70 is located in the frame area 110. As shown in FIG. 3, in this embodiment, the ELVSS power cable 70 has a cable width, and an edge part of the first electrode layer 10 may partially overlap the ELVSS power cable 70, but this is not limited thereto. The ELVSS power cable 70 and the first electrode layer 10 may be located in different layers and electrically connected to each other through a via.

Still refer to FIG. 2. FIG. 2 shows two ELVSS power cables 70 of the display panel, and the two ELVSS power cables 70 are both disposed in the frame area 110. A resistivity of the ELVSS power cable 70 is higher than a resistivity of the cable 51 of the first flexible circuit board 50 and a resistivity of the cable 61 of the second flexible circuit board 60. One end of each ELVSS power cable 70 is connected to the cable 51 of the first flexible circuit board 50, and extends across the side area 113 until the other end is connected to the cable 61 of the second flexible circuit board 60. The two ELVSS power cables 70 extend in different side areas 113, and are connected and joined on the cable 51 of the first flexible circuit board 50 and the cable 61 of the second flexible circuit board 60 that are in the two end side areas 111. The two ELVSS power cables 70, the cable 51 of the first flexible circuit board 50, and the cable 61 of the second flexible circuit board 60 are connected to form a loop. In this embodiment, two ends of the cable 51 of the first flexible circuit board 50 are respectively connected to the two ELVSS power cables 70, and two ends of the cable 61 of the second flexible circuit board 60 are also respectively connected to the two ELVSS power cables 70.

To reduce a front-side area occupied by the two end side areas 111 of the display apparatus, in this embodiment, the OLED display panel 100 is flexible and bent, but this is not limited thereto. In another embodiment, the OLED display panel 100 may alternatively be non-flexible. The OLED display panel 100 may use a COP bending (Chip on PI bending) process. In the COP, namely, a technical solution for a flexible OLED, usually a display drive chip (IC) is bonded (bonding) on a flexible substrate (a material may be polyimide, PI) through hot-press and then bent to a back of the display area, and then is connected to a display drive circuit board through a hetero-square conductive adhesive. FIG. 2 is a planar expanded diagram of the flexible and bent OLED display panel 100, and a location of a dashed line in FIG. 2 is a bending line at a bent part of the OLED display panel 100.

The ELVSS power signal is provided by a mainboard (not shown in the figure), and a power management integrated circuit (Power Management IC, PMIC) is disposed on the mainboard to output the ELVSS power signal. In this application, both the first flexible circuit board 50 and the second flexible circuit board 60 are electrically connected to the mainboard, to connect to and transmit the ELVSS power supply signal.

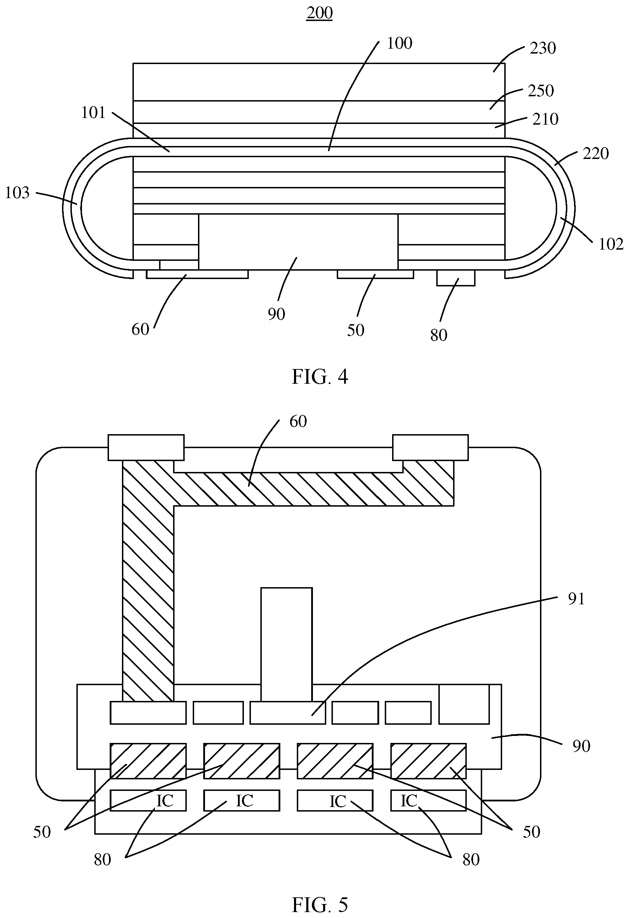

FIG. 4 is a side view diagram of an OLED display apparatus to which a flexible bent OLED display panel 100 is applied. FIG. 5 is a rear view of the OLED display apparatus. Refer to FIG. 4 and FIG. 5. Specifically, a mainboard is connected to a display drive circuit board 90 through a connector 91, a first flexible circuit board 50 and a second flexible circuit board 60 are both electrically connected to the display drive circuit board 90 to connect to an ELVSS power signal, and a cable 61 is disposed on each of the first flexible circuit board 50 and the second flexible circuit board 60 to lead out the ELVSS power signal and connect to an ELVSS power cable 70. In this way, the ELVSS power signal output by the mainboard sequentially passes through the connector 91, the display drive circuit board 90, the first flexible circuit board 50, the second flexible circuit board 60, and the ELVSS power cable 70, to arrive at the first electrode layer 10, thereby supplying power to the first electrode layer 10.

In some embodiments, materials of the cables 61 in the first flexible circuit board 50 and the second flexible circuit board 60 are metal copper, but this is not limited thereto. In some embodiments, the ELVSS power cable 70 is a TiAlTi cable, that is, a cable of a three-layer stacked structure formed by sequentially stacking a Ti layer, an Al layer, and a Ti layer, but this is not limited thereto. A power cable inside the OLED display is usually made of TiAlTi multi-layer metal, for dry etch to be easily performed on the metal.

It may be understood that because the OLED display panel is of a multi-layer stacked structure, the second flexible circuit board 60, the first flexible circuit board 50, and the ELVSS power cable 70 may be disposed at different layers, or certainly may be located at a same layer.

According to the display panel in this application, the second flexible circuit board 60 (for example, a touch flexible circuit board) is cleverly used to connect to the ELVSS power signal, the cable 61 (for example, a metal copper material) with a low resistivity is disposed to connect to and lead out the ELVSS power signal, and the cable 61 is connected to the ELVSS power cable 70 (for example, a TiAlTi three-layer stacked structure) with a high resistivity, so that a low-impedance lay out design of the ELVSS power cable 70 can be implemented, thereby reducing a voltage drop (where an actual voltage increases from 85% of an ELVSS voltage to 90% of the ELVSS voltage), and improving a display effect.

As shown in FIG. 2, a display drive chip (IC) 80 may be further disposed in the end side area 111, and the drive chip 80 and the first flexible circuit board 50 are located in a same end side area 111.

It may be understood that, as shown in FIG. 2, the OLED display panel 100 further includes a gate driver (Gate Driver) 115, an emission driver (Emission Driver) 116, and the like that are disposed in the two side areas 113, to connect to a pixel drive circuit in the TFT substrate 40. The gate driver 115 and the emission driver 116 are disposed between the display area 120 and the ELVSS power cable 70.

It may be understood that, as shown in FIG. 2, a dummy circuit (Dummy) 117, a multiplexer (MUX) 118, and the like may be further disposed in the two end side areas 111 of the OLED display panel.

In this application, the cable 51 with a low resistivity is disposed on the first flexible circuit board 50 and the cable 61 with a low resistivity is disposed on the second flexible circuit board 60, to reduce resistance of the ELVSS power cable 70. Therefore, a cable width of the ELVSS power cable 70 in the frame area 110 can be reduced. For example, a width of the ELVSS power cable 70 in the side area 113 may be reduced by 0.1 mm.

It may be understood that, when the OLED display panel is applied to a tablet computer or another electronic apparatus with a display of a large size, an area size of the first electrode layer 10 is also large. To ensure that different areas of the first electrode layer 10 can receive consistent ELVSS power voltages to ensure consistency of display pixels, the OLED display panel may further include a plurality of ELVSS power cables (not shown in the figure) extended in the display area 120, the plurality of ELVSS power cables are connected in parallel, are connected to the display flexible circuit board to receive an ELVSS power signal, and are connected to the first electrode layer 10 to transmit the ELVSS power signal to the first electrode layer 10. In this way, it is ensured that all areas of the entire first electrode layer 10 can evenly receive the ELVSS power voltage signal, thereby ensuring light emitting consistency of the pixels. In addition, to avoid affecting, by the plurality of ELVSS power cables 70 extending in the display area 120, light emission the organic light-emitting layer 20, the plurality of ELVSS power cables 70 need to be disposed in an area between pixels, instead of an area in which a pixel is located.

It may be understood that in this embodiment of this application, a layout design of the ELVSS power cable is used as an example for description. Similarly, a layout design of an ELVDD power cable may also refer to the layout design of the ELVSS power cable to reduce a voltage drop. Details are not described herein again.

Refer to FIG. 4. This application further provides an OLED display apparatus 200 including the foregoing OLED display panel 100. The OLED display apparatus 200 further includes a polarizer 210 and a transparent cover 230 that are stacked on a front surface of the OLED display panel 100. A transparent optical adhesive 250 is further disposed between the polarizer 210 and the transparent cover 230.

As shown in FIG. 4, in this embodiment, the OLED display panel 100 is flexible and bendable. The OLED display panel 100 includes a main part 101, and a first bent part 102 and a second bent part 103 that are connected to two opposite ends of the main part 101. The first bent part 102 and the second bent part 103 are bent to a back surface of the main part 101 relative to the main part 101. In FIG. 2, a location of a dashed line is a bending line at which the first bent part 102 and the second bent part 103 are bent relative to the main part 101. As shown in FIG. 4, the front surface of the OLED display panel 100 is further covered with a flexible packaging layer 220. In the OLED display apparatus 200, the packaging layer 220 and the OLED display panel 100 are bent together.

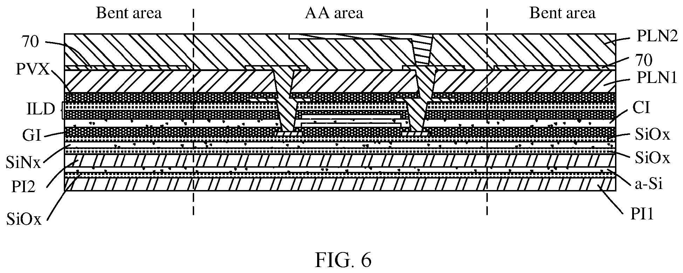

The first bent part 102 and the second bent part 103 are mainly formed by bending a part that is of a TFT substrate 40 and that is located in an end side area 111, and reference may be made to FIG. 6.

The main part 101 defines a display area 120 and two side areas 113, and the two end side areas 111 are defined by at least the first bent part 102 and the second bent part 103. In this way, the first bent part 102 and the second bent part 103 do not occupy too much size space of a front surface of the display panel, and a size of the front surface of the display panel occupied by the two end side areas 111 of the frame area 110 can be further reduced.

A first flexible circuit board 50 and a drive chip 80 are disposed on the first bent part 102 and are located on a surface that is of the first bent part 102 and that is away from the main part 101. A second flexible circuit board 60 is disposed on the second bent part 103 and is located on a surface that is of the second bent part 103 and that is away from the main part 101. As shown in FIG. 4 and FIG. 5, the OLED display apparatus 200 further includes a display drive circuit board 90 that is disposed on the back surface of the main part 101, and the display drive circuit board 90 is approximately located in an area between the first bent part 102 and the second bent part 103. The display drive circuit board 90 is electrically connected to a mainboard (not shown in the figure) through a connector 91 to connect to an ELVSS power supply signal. Both the first flexible circuit board 50 and the second flexible circuit board 60 are electrically connected to the display drive circuit board 90 to connect to the ELVSS power supply signal.

It may be understood that the OLED display panel 100 is flexible and bendable, and the TFT substrate 40 is flexible and bendable. The TFT substrate 40 is a conventional TFT substrate, and is of a multi-layer stacked structure. As shown in FIG. 6, the TFT substrate includes a flexible base (a polyimide layer, which is shown as PI1 in the figure), an insulation layer (SiOₓ), an a-Si layer, a second polyimide layer (PI2), an insulation layer (SiOₓ), an insulation layer (SiNₓ), an insulation layer (SiOₓ), a gate insulation layer (GI), an insulation layer (CI), an interlayer dielectric layer (ILD), a passivation layer (PVX), and planarization layers (PLN1 and PLN2) that are sequentially stacked from bottom to top. A TFT (not shown in the figure), a capacitor (not shown in the figure), and the like of a pixel drive circuit are formed in the multi-layer stacked structure. As shown in FIG. 6, in this embodiment, an ELVSS power cable 70 is disposed on the planarization layer (PLN1). In another embodiment, the ELVSS power cable 70 may be disposed on one of the insulation layer, the passivation layer, the interlayer dielectric layer, or the planarization layers of the TFT substrate 40.

The OLED display apparatus 200 further includes a touch layer (not shown in the figure). The touch layer may be stacked between the display panel and the polarizer 210, or may be stacked between the polarizer 210 and the transparent cover 230, but this is not limited thereto. In this application, the touch layer is external. The touch layer is connected to a touch flexible circuit board.

It may be understood that, as shown in FIG. 4, the OLED display apparatus 200 further includes some conventional stacked layers (not shown in the figure) that are stacked below the main part 101 of the OLED display panel 100.

The foregoing descriptions are merely specific implementations of this application, but are not intended to limit the protection scope of this application. Any variation or replacement readily figured out by a person skilled in the art within the technical scope disclosed in this application shall fall within the protection scope of this application. When no conflict occurs, the implementations of this application and the features in the implementations may be mutually combined. Therefore, the protection scope of this application shall be subject to the protection scope of the claims.

## Claims

1. A display panel, comprising a first electrode layer, an organic light-emitting layer, and a second electrode layer that are sequentially stacked, wherein the display panel is divided into a display area and a frame area, the frame area comprises a first end side area and a second end side area that are opposite to each other, and two opposite side areas that are connected between the first end side area and the second end side area, and the display panel comprises:
a first flexible circuit board disposed in the first end side area and a second flexible circuit board disposed in the second end side area, wherein the first flexible circuit board and the second flexible circuit board obtain, through respective cables, a drive signal provided by a mainboard for the first electrode layer; and
two power cables, wherein each power cable has two opposite ends, one end of each power cable is connected to the cable of the first flexible circuit board, and the other end is connected to the cable of the second flexible circuit board, for the two power cables, the cable of the first flexible circuit board, and the cable of the second flexible circuit board to be connected to form a loop, and the two power cables are both electrically connected to the first electrode layer.

2. The display panel according to claim 1, wherein a resistivity of the power cable is higher than a resistivity of the cable of the first flexible circuit board and a resistivity of the cable of the second flexible circuit board.

3. The display panel according to claim 1 or 2, wherein the first flexible circuit board is a display flexible circuit board, and the second flexible circuit board is a touch flexible circuit board.

4. The display panel according to any one of claims 1 to 3, wherein the two power cables are respectively disposed in the two different side areas.

5. The display panel according to any one of claims 1 to 4, wherein the drive signal is an ELVSS voltage signal.

6. The display panel according to claim 5, wherein the first electrode layer is an entire layer covering at least the display area.

7. The display panel according to any one of claims 1 to 6, wherein a material of the cable in the first flexible circuit board and a material of the cable in the second flexible circuit board are both metal copper.

8. The display panel according to any one of claims 1 to 7, wherein the power cable is a TiAlTi cable.

9. The display panel according to any one of claims 1 to 8, wherein the display panel is flexible, and comprises a main part, and a first bent part and a second bent part that are connected to two opposite ends of the main part, wherein the first bent part and the second bent part are bent relative to the main part and are stacked on a back surface of the main part.

10. The display panel according to claim 9, wherein the first flexible circuit board is disposed on the first bent part and is located on a surface that is of the first bent part and that is away from the main part, and the second flexible circuit board is disposed on the second bent part and is located on a surface that is of the second bent part and that is away from the main part.

11. The display panel according to claim 9, wherein the display panel comprises a thin film transistor substrate stacked on a side that is of the second electrode layer and that is away from the organic light-emitting layer, and the thin film transistor substrate is flexible and comprises a flexible base.

12. The display panel according to any one of claims 1 to 11, wherein the display panel further comprises a plurality of other power cables extending in the display area, the plurality of other power cables are connected in parallel and electrically connected to the first electrode layer, and the plurality of other power cables are electrically connected to the cable of the first flexible circuit board or the cable of the second flexible circuit board.

13. A display apparatus, comprising the display panel according to any one of claims 1 to 12, and a polarizer and a transparent cover that are disposed on the display substrate.

14. The display apparatus according to claim 13, wherein the display apparatus further comprises a touch layer stacked on the display panel.

15. The display apparatus according to claim 13, wherein the display apparatus further comprises a display drive circuit board, the display drive circuit board is electrically connected to a mainboard to obtain a drive signal, and both the first flexible circuit board and the second flexible circuit board are electrically connected to the display drive circuit board to obtain the drive signal.
